# EUROPÄISCHE PATENTSCHRIFT

(11) **EP 1 320 914 B1**
(45) Veröffentlichungstag und Bekanntmachung des Hinweises auf die Patenterteilung: **12.08.2009**
(21) Anmeldenummer: 01982163.6
(22) Anmeldetag: 25.09.2001
(51) Int. Cl.: H01S 5/028

(54) **PASSIVIERUNG DER RESONATORENDFLÄCHEN VON HALBLEITERLASERN AUF DER BASIS VON III-V-HALBLEITERMATERIAL**
METHOD FOR PASSIVATING THE RESONATOR END FACES OF SEMICONDUCTOR LASERS ON THE BASIS OF III-V SEMICONDUCTOR MATERIAL
PASSIVATION DES FACES TERMINALES DE RESONATEUR DE LASERS SEMI-CONDUCTEURS A BASE DE MATERIAU SEMI-CONDUCTEUR III-V

(30) Priorität: 29.09.2000 DE 10048475
(43) Veröffentlichungstag der Anmeldung: 25.06.2003
(73) Patentinhaber: Lumics GmbH, 12489 Berlin (DE)
(72) Erfinder: HÄUSLER, Karl, 12559 Berlin (DE); KIRSTAEDTER, Nils, 12435 Berlin (DE); EBERL, Karl, 71263 Weil der Stadt (DE)
(74) Vertreter: Graf Lambsdorff, Matthias
(86) Internationale Anmeldenummer: PCT/DE2001/003723
(87) Internationale Veröffentlichungsnummer: WO 2002/027875

(56) Entgegenhaltungen:
- EP-A- 0 416 190
- US-A- 5 799 028
- KAZUAKI SASAKI: "REALIZATION OF HIGHLY RELIABLE HIGH-POWER OPERATION OF SINGLE- STRIPE AIGAAS LASERS BY THE FORMATION OF WINDOW GROWN ON FACETS" JAPANESE JOURNAL OF APPLIED PHYSICS, PUBLICATION OFFICE JAPANESE JOURNAL OF APPLIED PHYSICS. TOKYO, JP, 27. August 1991 (1991-08-27), Seiten 111-113, XP000279426 ISSN: 0021-4922
- PATENT ABSTRACTS OF JAPAN vol. 013, no. 393 (E-814), 31. August 1989 (1989-08-31) & JP 01 138784 A (NEC CORP), 31. Mai 1989 (1989-05-31)
- PATENT ABSTRACTS OF JAPAN vol. 2000, no. 08, 6. Oktober 2000 (2000-10-06) & JP 2000 133870 A (FURUKAWA ELECTRIC CO LTD:THE), 12. Mai 2000 (2000-05-12)

## Beschreibung

Die vorliegende Erfindung betrifft generell das Gebiet der Herstellung von Halbleiterlasern auf der Basis von III-V-Halbleitermaterial, insbesondere solcher Halbleiterlaser, die durch Abspaltung von einem größeren Halbleiterkristall (Barren) hervorgehen und demzufolge Spaltkanten aufweisen. Insbesondere bezieht sich die Erfindung dabei auf ein Verfahren zur Passivierung dieser Spaltkanten oder allgemein der Resonatorendflächen von Halbleiterlasern.

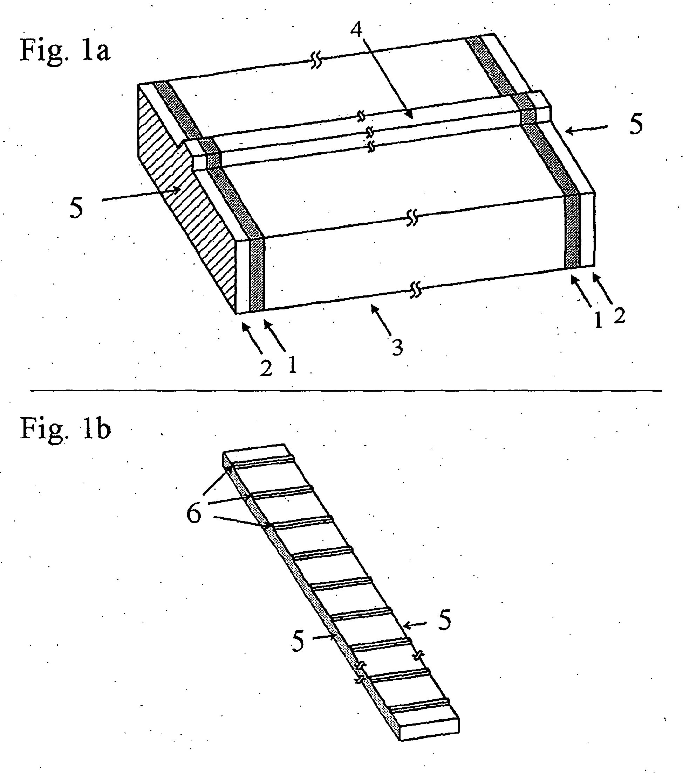

Zunächst wird die konventionelle Herstellung der Halbleiterlaser anhand der Figuren 1a,b näher erläutert.

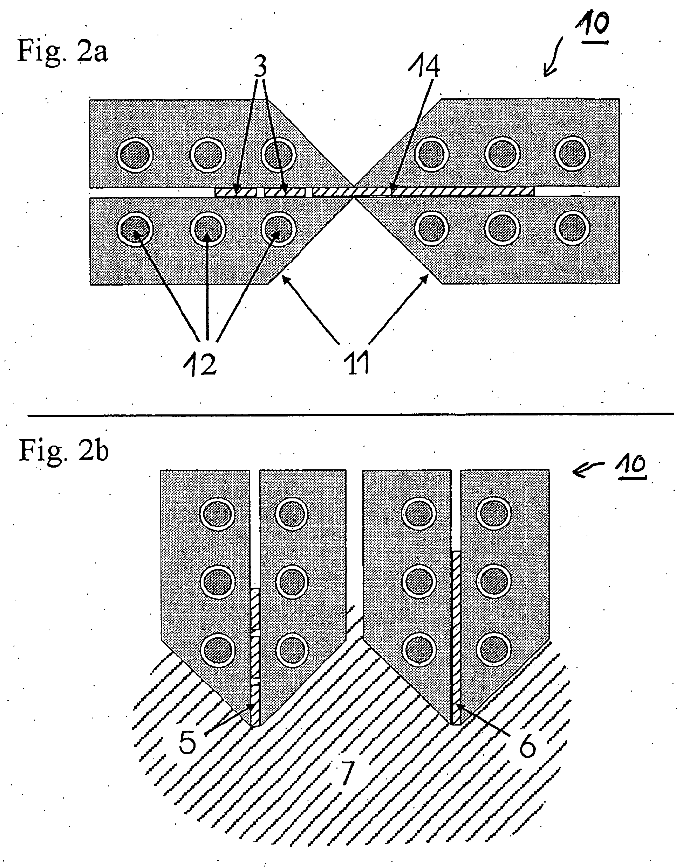

Die Herstellung erfolgt im Wesentlichen in drei Schritten. Erstens wird eine Laserstruktur durch epitaktische Beschichtung eines Halbleiterkristalls hergestellt. Zweitens wird die Laserstruktur lithographisch prozessiert und mit Kontaktmetall versehen. Drittens werden die Laserspiegel durch Spalten des Kristalls entlang der [110]-Kristallachsen (bei polaren Verbindungshalbleitern) erzeugt. Durch diesen Spaltvorgang wird auch die Resonatorlänge des Lasers festgelegt, der durch zwei gegenüberliegende Spaltflächen 5 begrenzt ist, welche als Spiegel dienen. Der Spaltvorgang liefert einen Halbleiterstreifen (Laserbarren), der eine Vielzahl von Laserdioden enthält. Die Laserdioden können aus vorstrukturierten Streifen 4 bestehen, die nebeneinander auf dem Laserbarren (Fig.2a) angeordnet sind. Die einzelnen Laserdioden 6 können von dem Läserbarren abgespalten werden.

Von dieser Erfindung abweichende Verfahren zur Passivierung der Spaltkante von Halbleiter-Laserdioden sind bekannt (z.B. US 4656638, US 5063173, US 5665637, US 5933705). Der Nutzen der Passivierung äußert sich in einer signifikanten Erhöhung der Lebensdauer der Laserdiode bei hoher optischer Ausgangsleistung. Der Effekt der Passivierung ist auf das Problem zurückzuführen, dass die Oberfläche von Halbleiterkristallen Defekte aufweist, die von ungesättigten Oberflächenbindungen und von Oxiden und Verunreinigungen stammen, welche in der Atmosphäre gebildet.werden. Während des Betriebs der Laserdiode führen diese Oberflächendefekte zur Absorption des Laserlichts an der Spaltkante, die zugleich als Spiegelfläche des Lasers dient. Folglich erwärmt sich die Spiegelfläche, wodurch bei hoher optischer Leistungsdichte eine plötzliche Zerstörung der Laserdiode ausgelöst wird. Dieser Effekt wird in der Literatur als katastrophale optische Spiegelzerstörung ("catastrophic optical mirror damage") beschrieben (Zeitschrift "APPLIED PHYSICS LETTERS", Jahrgang 1998, Heft 73 (9), Seiten 1182 - 1184). Durch Passivierung wird die Dichte der Oberflächendefekte durch teilweise Sättigung der Oberflächenbindungen reduziert (Zeitschrift "JOURNAL OF APPLIED PHYSICS", Jahrgang 2000, Heft 87 (11), Seiten 7838 - 7844). Zugleich werden Oxidation und Verunreinigung verhindert (US 5063173).

Nach dem bisherigen Stand der Technik wird die Passivierung der Spaltkante von Halbleiter-Laserdioden mit dünnen Schichten bestehend aus den Elementen Si, Ge oder Sb (US 5063173) oder den 11-VI-Verbindungshalbleitern (US 5665637), wie ZnSe, und anderen Materialien (z.B. US 4656638, EP 845839) durchgeführt. Bislang wurde die Abscheidung der Passivierungsschicht nur für solche Halbleiter-Laserdioden vorgenommen, die vor der Passivierung bereits mit Kontaktmetall versehen waren. Daher sind die bisherigen Verfahren wesentlichen Einschränkungen in der Wahl der Materialien und Parameter unterworfen. Dies ist im Wesentlichen auf zwei Gründe zurückzuführen. Erstens führt die zur optimalen Abscheidung notwendige hohe Substrattemperatur (z.B. 500 - 600°C für InGaAsP mittels Molekularstrahlepitaxie) zu einer irreparablen Zerstörung des ohmschen Kontaktwiderstands durch Diffusion des Kontaktmetalls. Zweitens verunreinigt das Kontaktmetall durch Ausgasen den Reaktor, in welchem die Epitaxie vorgenommen wird. Diese Verunreinigungen gelangen dann auf die Spaltkante.

Infolge dessen war bisher die Wahl der Verfahren und Materialien für die Passivierung auf solche beschränkt, für welche die Temperatur des Substrats während der Abscheidung wesentlich kleiner ist als die Temperatur für die Diffusion des Kontaktmetalls (350 - 400°C) (US 5933705). Beispielsweise werden die Elemente Si, Ge, Sb und andere für die Passivierung geeignete Materialien bei Raumtemperatur abgeschieden. Die optimale Substrattemperatur für die Epitaxie von ZnSe auf GaAs-basierenden Halbleitersubstraten beträgt 250°C (Zeitschrift "APPLIED PHYSICS A, Jahrgang 1999, Heft 68, Seiten 627 - 629). Daher werden bei niedriger Temperatur abgeschiedene ZnSe-Schichten für die Passivierung verwendet.

Die nach dem bisherigen Stand der Technik angewendeten Verfahren für die Passivierung von Spaltkanten bieten keinen vollständigen Schutz vor katastrophaler optischer Spiegelzerstörung (Zeitschrift "ELECTRONICS LEITERS", Jahrgang 1999, Heft 35 (6) Seiten 506 - 508). Die passivierten Hochleistungs-Laserdioden, die als Pumplaser für optische Faserverstärker eingesetzt werden, erleiden bei sehr hoher optischer Leistungsdichte (z.B. einige 10⁸W/cm²) katastrophale optische Spiegelzerstörung. Dies wird auf zwei wesentliche Nachteile der bekannten Verfahren zurückgeführt. Erstens weisen die passivierten Spaltkanten noch eine hohe Dichte an Absorptionszentren auf. Die Absorptionszentren sind auf Defekte zurückzuführen, die das vom Laser emittierte Licht zu absorbieren vermögen und z.B. von ungesättigten Oberflächenbindungen, Punktdefekten, Versetzungen, Oxiden und Verunreinigungen gebildet werden. Zweitens sind die Materialien über lange Zeiträume strukturell instabil.

Der Nachteil einer mit Si passivierten Spaltkante eines GaAs-Substrats liegt darin, dass die Dichte der Absorptionszentren hoch ist (etwa 10¹⁰cm⁻²eV⁻¹) (Zeitschrift "VACUUM", Jahrgang 2000, Heft 57, Seiten 111 - 120). Ein weiterer Nachteil ergibt sich aus der Tatsache, dass Schichten, die aus den Elementen Si, Ge oder Sb bestehen, auf III-V-Halbleitersubstraten (z.B. GaAs) polykristallin oder amorph sind und daher rekristallisieren können. Diese strukturelle Instabilität kann zur Ausbildung von Oberflächendefekten führen, welche wiederum zur katastrophalen optischen Zerstörung beitragen.

Der Nachteil einer Passivierung der Spaltkante mit ZnSe ist auf eine verminderte Kristallqualität zurückzuführen (Zeitschrift "APPLIED PHYSICS A, Jahrgang 1999, Heft 68, Seiten 627 - 629). Die mittels Epitaxie auf (011)- GaAs abgeschiedenen ZnSeSchichten zeigen Kristalldefekte von hoher Dichte und Oberflächenräuhigkeit. Die auf dem Kristallwachstum von ZnSe auf (011)- GaAs basierenden Laserdioden degradieren bekanntlich schnell, wodurch die schlechte Kristallqualität des ZnSe auf (011)- GaAs belegt wird.

Andere Materialien und Verfahren, die nach dem Stand der Technik zur Passivierung verwendet werden, weisen gleichfalls Nachteile auf. Derartig passivierte Laserdioden erleiden katastrophische optische Spiegelzerstörung schon bei kleinerer Belastung als die Laserdioden, welche mit Si oder ZnSe passiviert sind (z.B. (Zeitschrift "ELECTRONICS LETTERS", Jahrgang 1999, Heft 35 (6) Seiten 506 - 508), oder mit AlGaAs (z.B. Zeitschrift Japanese Journal of Applied Physics, 27. Aug. 1991, Seiten 111 - 113, K. Sasaki).

Der vorliegenden Erfindung liegt die Aufgabe zugrunde, einen Halbleiterlaser Basis von III-V-Halbleitermaterial mit erhöhter Lebensdauer und ein Verfahren zu seiner Herstellung anzugeben. Insbesondere besteht die Aufgabe darin, die Gefahr der katastrophalen optischen Spiegelzerstörung bei extrem hoher Dichte der optischen Leistung zu reduzieren oder vollständig zu vermeiden.

Diese Aufgabe wird durch die Merkmale der unabhängigen Patentansprüche gelöst. Vorteilhafte Weiterbildungen sind in den Unteransprüchen angegeben.

Die Erfindung besteht in einem Halbleiterlaser mit erfindungsgemäß passivierten Resonatorendflächen, einem Verfahren zum Herstellen der Passivierungsschichten, in weiteren in Unteransprüchen definierten Verfahrensschritten, die entweder vor oder nach dem Aufbringen der Passivierungsschichten erfolgen und vorteilhaft mit dem Passivierungsverfahren zusammenwirken, einer Vorrichtung zum Spalten der Halbleiterlaser und zum epitaktischen Aufwachsen der Passivierungsschichten und einer'Vorrichtung zum gleichzeitigen Aufbringen von metallischen Kontaktierungsschichten auf eine Mehrzahl von Halbleiterlasern.

Ein wesentlicher Gedanke der vorliegenden Erfindung besteht darin, die Passivierung der Resonätorendflächen dadurch zu verbessern, indem die Defekte an der Resonatorendfläche nahezu vollständig passiviert werden. Dies wird durch Abscheiden einer einer epitaktischen InₓGa₁₋ₓAs_{y}P_{1-y} -Schicht (0 < x < 1 und 0 < y < 1) auf der Resonatorendfläche erreicht. Die Wahl dieses Materials ermöglicht eine Verminderung der Dichte von Absorptionszentren an der Resonatorendfläche im Vergleich zum Stand der Technik und zugleich eine stabile Schutzschicht gegen die Korrosion des Halbleiterlasers. Durch dieses Material und dessen epitaktisches Aufwachsen werden im Idealfall alle Oberflächenbindungen auf der Resonatorendfläche abgesättigt, da die auf III-V-Halbleitermaterial basierende Halbleiterstruktur durch die InₓGa₁₋ₓAs_{y}P_{1-y}-Schicht fortgesetzt wird.

Der Halbleiterlaser selbst kann im Prinzip aus jedem beliebigen binären, ternären oder quaternären III-V-Halbleitermaterial bestehen.

Besonders vorteilhaft kann die Erfindung bei solchen Halbleiterlasern angewandt werden, die durch Spaltung von einem größeren epitaktisch gewachsenen Halbleiterkristall (Barren) gewonnen werden, bei denen also die Resonatorendflächen durch Spaltkanten gebildet werden. In diesem Fall kann die Erfindung vorteilhaft dahingehend weitergebildet werden, daß die Spaltung des Halbleiterkristalls in derselben Vorrichtung vorgenommen wird, indem auch das epitaktische Aufwachsen der Passivierungsschicht vorgenommen wird, wie weiter unten noch erläutert werden wird.

Der Erfindung liegt unter anderem der Gedanke zugrunde, daß die elektrische Kontaktierung, also das Aufbringen von metallischen Beschichtungen für die elektrische Kontaktierung der Laserdiode erst dann vorgenommen wird, nachdem das Aufbringen der Passivierungsschicht erfolgt ist. Erst dadurch wird es möglich, eine relativ hohe Substrattemperatur (z.B. 500°C - 600°C) für die Epitaxie einzusetzen.

Eine weitergehende Aufgabe der vorliegenden Erfindung, eine weitgehende Vermeidung von Verunreinigung auf der Spaltflächen zu erreichen, wird dadurch gelöst, dass die zur Herstellung der Spaltkante notwendige Kristallspaltung in-situ vorgenommen wird. Das heisst, der Kristall wird innerhalb des Reaktors gespalten, in dem die Epitaxie durchgeführt wird, da Epitaxie-reaktoren stets minimale Konzentration von Sauerstoff und Verunreinigungen aufweisen. Dadurch wird eine Oxidation der Spaltkante vor Aufbringen der Epitaxieschicht vermieden. Solche insitu-Spaltvorgänge mit anschließendem Kristallwachstum auf der Spaltkante wurden zwar bereits in der Literatur beschrieben und sind als "cleaved edge overgrowth" (CEO) bekannt. Bisher wurde lediglich epitaktisches Abscheiden von Arseniden, wie GaAs und AlGaAs auf der Spaltkante eines beschichteten GaAs-Substrats mittels CEO beschrieben, allerdings nicht im Zusammenhang mit Passivierung von Laserfacetten. Das heteroepitaktische Abscheiden von InₓGa₁₋ₓAs_{y}P_{1-y} auf der Spaltkante mittels CEO wird in dieser Erfindung erstmals dargestellt.

In einer besonders vorteilhaften Ausführungsart der Erfindung wird in ein und derselben Vorrichtung ein Halbleiterkristall in einzelne Halbleiterlaser gespalten, auf eine bestimmte Temperatur aufgeheizt und epitaktisch mit der Passivierungsschicht beschichtet. Dies kann durch Verwendung einer speziellen Vorrichtung erfolgen, die in Fig. 2 dargestellt ist.

In dieser Vorrichtung wird der Halbleiterkristall 4 in die Vorrichtung 10 geklemmt. Danach wird der Kristall mittels in der Vorrichtung eingebauter Heizstäbe 12 auf die erforderliche Substrattemperatur gebracht. Das Aufheizen vor der Kristallspaltung dient zum Ausgasen der Vorrichtung. Nach Einstellen der erforderlichen Substrattemperatur wird die zur Epitaxie benötigte Atmosphäre (Abb. 2b, 7) zugeführt. Diese Atmosphäre besteht aus Molekularstrahl, Gas oder Flüssigkeit je nach verwendetem Epitaxieverfahren (z.B. Molekularstrahlepitaxie, Gasphasenepitaxie, Flüssigphasenepitaxie). Anschliessend wird der Kristall durch Drehen um die Spaltkante (Drehachse) gespalten. Das Drehen erfolgt z.B. bei III-V-Halbleitersubstrat um die [110]-Kristallachse, deren Richtung die natürliche Spaltkante vorgibt. Die epitaktische Schicht wird dann auf beiden Spaltkanten 5, 6 gleichzeitig abgeschieden. Sobald die erforderliche Schichtdicke erreicht ist, wird die Zufuhr der epitaktischen Atmosphäre unterbrochen. Das Resultat dieses Prozesses sind beidseitig passivierte Laserbarren, die durch Wiederholung des Prozesses hergestellt werden.

Die Dichte der Absorptionszentren auf der InₓGa₁₋ₓAs_{y}P_{1-y} - Passivierungsschicht kann dadurch reduziert werden, indem eine zweite Passivierungsschicht, vorzugsweise ebenfalls in-situ, d.h. in demselben Reaktor, auf dem InₓGa₁₋ₓAs_{y}P_{1-y} abgeschieden wird. Das heisst, die Abscheidung der zweiten Schicht erfolgt in der Epitaxieanlage oder in einer direkt daran angeschlossenen Kammer. Diese Schicht kann aus der Gruppe der Materialien Si, Ge, Sb, SiNₓ, GaNₓ, ZnSe, ZnS, GaO₂, SiOₓ, Al₂O₃, ausgewählt werden.

Ein alternatives Verfahren für die Abscheidung einer Phosphidschicht auf GaAs-basierenden Halbleitern ist die Austauschreaktion von Arsen und Phosphor mittels eines Trägergases, wie Tertiarybutylphosphine (TBP), in einem Gasphasen-Epitaxiereaktor. Die Aufgabe epitaktisches InₓGa₁₋ₓAs_{y}P_{1-y} durch Austauschreaktion zur Passivierung der Spaltkante herzustellen wird nach den Merkmalen des Patentanspruchs 6 gelöst.

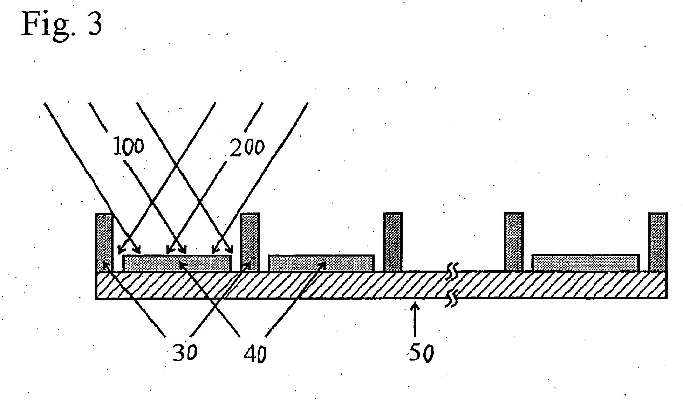

Die Aufgabe, das Kontaktmetall nach der Passivierung auf die gespaltenen Laserbarren aufzubringen, wird durch eine spezielle Vorrichtung (Fig. 3) gelöst. Diese Vorrichtung ermöglicht es die Laserbarren 4 so mit dem Metall zu beschichten, dass die Spiegelflächen nicht kontaminiert werden. Die Vorrichtung besteht aus einer flachen. Scheibe 5, auf welcher die Laserbarren z.B. durch Federn festgeklemmt werden. Direkt an die Spiegelfacetten der Laserbarren grenzen streifenförmige Erhebungen 3 an, die als Schattenmasken dienen. Die Metalldeposition wird in einer Metallbeschichtungsanlage durchgeführt, in welcher ein gerichteter Metallstrahl von einer lokalisierten Quelle ausgeht. Solche Anlagen sind als Elektronenstrahlverdampfer oder Sputteranlagen bekannt. Die Beschichtung wird so durchgeführt, dass der erste Metallstrahl 1 in einem kleinen Winkel zur Vertikalen auf die Laserbarren auftritt. Der Winkel wird so gewählt, dass beide Spiegelfacetten im Schatten des Strahls liegen und zugleich eine möglichst grosse Fläche.des Laserbarrens bedampft wird. Durch einen zweiten Strahl 2 wird der Bereich auf der Oberfläche des Laserbarrens beschichtet, der im Schatten des ersten Strahls liegt. Alternativ kann der zweite Strahl auch von derselben Quelle stammen und nach der ersten Beschichtung durch Drehen der Vorrichtung um den entsprechenden Winkel zur Metallisierung des Laserbarrens dienen.

### Die beigefügten Zeichnungen zeigen im einzelnen:

In den Figuren 1a und 1b sind strukturierte Laser in Form eines Chips 1a und in Form eines Laserbarren 1b gezeigt. Fig. 1a zeigt den Halbleiterkristall 3 auf welchem ein Laserstreifen 4 durch Lithographie hergestellt ist. Die Laserfacetten 5 sind mit zwei Passivierungsschichten 1, 2 versehen. Die erste Schicht 1 besteht aus InₓGa₁₋ₓAs_{y}P_{1-y}, das bei durch Epitaxie' aufgebracht ist. Die zweite Schicht 2 ist eine Passivierungsschicht für InₓGa₁₋ₓAs_{y}P_{1-y}, die z.B. nach den Merkmalen des Patentanspruchs 5 aus der Gruppe der Materialien Si, Ge, Sb, SiNₓ, GaNₓ, GaO₂, SiOₓ, Al₂O₃, ZnSe, ZnS ausgewählt ist.

In den Figuren 2a und 2b werden die Vorrichtung und das Verfahren für die in-situ- Spaltung mit anschliessender Epitaxie bei hoher Temperatur schematisch dargestellt. Fig. 2a zeigt zwei heizbare Klemmvorrichtungen 1, die den Halbleiterkristall 4 und dessen abgespaltene Laserbarren 3 festhalten. Die Klemmvorrichtung besteht aus Metall oder Keramik ist z.B. mit keramisch isolierten Heizstäben versehen, die den Halbleiterkristall auf die für die Epitaxie erforderliche Substrattemperatur aufzuheizen vermögen. Alternativ kann hierfür auch Heizstrahlung verwendet werden. In Fig. 2b ist die dem Spaltvorgang folgende epitaktische Abscheidung des Materials 7, z.B. InₓGa₁₋ₓAs_{y}P_{1-y} gezeigt. Das Material wird entweder unmittelbar nach dem Spaltvorgang oder bereits während der Spaltung auf den Spaltflächen 5, 6 des Halbleiterkristalls abgeschieden.

In Figur 3 sind die Vorrichtung und das Verfahren für das Abscheiden des Kontaktmetalls auf den passivierten Laserbarren schematisch dargestellt. Die Laserbarren 40 sind auf einer Scheibe 50 z.B. durch Federn festgeklemmt. Die Laserbarren 40 sind so durch Schattenmasken 30 geschützt, dass die Metallstrahlen 100, 200 während der Abscheidung des Kontaktmetalls nicht auf die Spaltkanten treffen.

## Patentansprüche

1. Halbleiterlaser auf der Basis von III-V-Halbleitermaterial, bei welchem
- auf mindestens eine äußere Oberfläche des Halbleiterlasers, welche eine Resonatorendfläche bildet, eine erste Passivierungsschicht (1) aus III-V Halbleitermaterial aufgebracht ist,
**dadurch gekennzeichnet, daß**
- dass III-V Halbleitermaterial der Verbindungshalbleiter InₓGa₁₋ₓAs_{y}P_{1-y} (0 < x < 1 und 0 < y < 1) ist.

2. Halbleiterlaser nach Anspruch 1,
**dadurch gekennzeichnet, daß**
- auf die äußere Oberfläche der Verbindungshalbleiter-Schicht (1) eine zweite Passivierungsschicht (2) aufgebracht ist.

3. Halbleiterlaser nach Anspruch 2,
**dadurch gekennzeichnet, daß**
- die zweite Passivierungsschicht (2) aus der Gruppe der Materialien Si, Ge, Sb, SiNₓ, GaNₓ, GaO₂ SiOₓ, Al₂O₃, ZnSe, ZnS ausgewählt ist.

4. Halbleiterlaser nach einem der vorhergehenden Ansprüche,
**dadurch gekennzeichnet, daß**
- er vor dem Aufbringen der ersten Passivierungsschicht (1) durch Abspaltung von einem größeren Halbleiterkristall (Barren) hervorgegangen ist, und
- die Resonatorendfläche eine Spaltkante des Halbleiterlasers ist.

5. Halbleiterlaser nach einem der vorhergehenden Ansprüche,
**dadurch gekennzeichnet, daß**
- auf beide äußere Oberflächen, welche Resonatorendflächen bilden, erste Passivierungsschichten (1) des Verbindungshalbleiters aufgebracht werden.

6. Verfahren zur Passivierung der Resonatorendfläche eines Halbleiterlasers auf der Basis von III-V-Halbleitermaterial,
**dadurch gekennzeichnet, daß**
- auf die Resonatorendfläche eine erste Passivierungsschicht (1) des Verbindungshalbleiters InₓGa₁₋ₓAs_{y}P_{1-y} (0 < x < 1 und 0 < y < 1) mittels Epitaxie aufgewachsen wird.

7. Verfahren nach Patentanspruch 6,
**dadurch gekennzeichnet, daß**
- der Halbleiterlaser vor dem Aufwachsen der ersten Passivierungsschicht (1) noch nicht mit. Kontaktmetall versehen wird,
- das epitaktische Aufwachsen der ersten Passivierungsschicht (1) bei einer Temperatur erfolgt, die höher als die Diffusionstemperatur des zu verwendenden Kontaktmetall ist,
- das Kontaktmetall nach dem Aufwachsen der ersten Passivierungsschicht (1) abgeschieden wird.

8. Verfahren nach einem der Ansprüche 6 oder 7,
**dadurch gekennzeichnet, daß**
- der Halbleiterlaser oder ein zu dem Halbleiterlaser zu verarbeitendes Zwischenprodukt vor dem Aufwachsen der ersten Passivierungsschicht (1) von einem größeren Halbleiterkristall (Barren) abgespalten wird, so daß
- die Resonatorendflächen durch die Spaltkanten gebildet werden.

9. Verfahren nach Anspruch 8,
**dadurch gekennzeichnet, daß**
- der Halbleiterlaser innerhalb des für das Aufwachsen der ersten Passivierungsschicht (1) verwendeten Epitaxiereaktors gespalten wird.

10. Verfahren nach einem der vorhergehenden Ansprüche,
**dadurch gekennzeichnet, daß**
- nach dem Aufbringen der ersten Passivierungsschicht (1) auf dessen äußerer Oberfläche eine zweite Passivierungsschicht (2) abgeschieden wird,
- welche aus einem Material besteht, durch die die Oberfläche der ersten Passivierungsschicht (1) passiviert werden kann.

11. Verfahren nach Anspruch 10,
**dadurch gekennzeichnet, daß**
- die zweite Passivierungsschicht (2) aus der Gruppe der Materialien Si, Ge, Sb, SiNₓ, GaNₓ, GaO₂, SiOₓ, Al₂O₃, ZnSe, ZnS ausgewählt ist.

12. Verfahren nach einem der vorhergehenden Ansprüche,
**dadurch gekennzeichnet, daß**
- die erste Passivierungsschicht (1) durch eine Austauschreaktion zwischen As und P erzeugt wird, wodurch eine dünne Inₓ-Ga₁₋ₓAs_{y}P_{1-y} (0 < x < 1 und 0 < y < 1) - Schicht (1) entsteht.

13. Verfahren nach einem der Ansprüche 8 bis 12,
**dadurch gekennzeichnet, daß**
- ein Halbleiterkristall (14) in eine Vorrichtung (10) geklemmt wird,
- der Kristall (14) mittels in der Vorrichtung (10) eingebauter Heizstäbe (12) oder durch Heizstrahlung auf die erforderliche Substrattemperatur gebracht wird,
- die für das epitaktische Aufwachsen der ersten Passivierungsschicht (1) erforderliche Atmosphäre (Molekularstrahl, Gas, Flüssigkeit) zugeführt wird,
- der Kristall (14) durch Drehen um die Spaltkante (Drehachse) gespalten wird,
- die erste Passivierungsschicht (1) auf einer oder auf beiden Spaltkanten gleichzeitig abgeschieden wird.

14. Verfahren nach einem der vorhergehenden Ansprüche,
**dadurch gekennzeichnet, daß**
- eine Anzahl von mit ersten und gegebenenfalls zweiten Passivierungsschichten (1, 2) versehenen Halbleiterlasern in einer Vorrichtung mit Schattenmasken (30) fixiert werden,
- das Kontaktmetall durch zwei gerichtete Strahlen (100, 200) abgeschieden wird, die in einem Winkel so auf die Laserbarren auftreffen, dass die gesamte Fläche des Lasers beschichtet wird, aber die Laserspiegel auf Grund der Schattenmasken nicht mit Metall kontaminiert werden.

## Claims

1. Semiconductor laser based on III-V semiconductor material, in which
- a first passivation layer (1) of III-V semiconductor material is applied to at least one outer surface of the semiconductor laser, which forms a resonator end face,
**characterized in that**
- the III-V semiconductor material is the compound semiconductor InₓGa₁₋ₓAs_{y}P_{1-y} (0 < x < 1 and 0 < y < 1).

2. Semiconductor laser according to claim 1,
**characterized in that**
- a second passivation layer (2) is applied to the outer surface of the compound semiconductor layer (1).

3. Semiconductor laser according to claim 2,
**characterized in that**
- the second passivation layer (2) is selected from the group of materials Si, Ge, Sb, SiNₓ, GaNₓ, GaO₂, SiOₓ, Al₂O₃, ZnSe, ZnS.

4. Semiconductor laser according to one of the preceding claims,
**characterized in that**
- before the first passivation layer (1) is applied, the laser has been made from a larger semiconductor crystal (bar) by cleaving, and
- the resonator end face is a cleaved edge of the semiconductor laser.

5. Semiconductor laser according to one of the preceding claims,
**characterized in that**
- first passivation layers (1) of the compound semiconductor are applied to both outer surfaces which form resonator end faces.

6. Method for passivating the resonator end face of a semiconductor laser based on III-V semiconductor material,
**characterized in that**
- a first passivation layer (1) of the compound semiconductor InₓGa₁₋ₓAs_{y}P_{1-y} (0 < x < 1 and 0 < y < 1) is grown onto the resonator end face by means of epitaxy.

7. Method according to claim 6,
**characterized in that**
- the semiconductor laser has not yet been provided with contact metal before the first passivation layer (1) is grown on,
- the epitaxial growth of the first passivation layer (1) takes place at a temperature which is higher than the diffusion temperature of the contact metal which is to be used,
- the contact metal is deposited after the first passivation layer (1) has been grown on.

8. Method according to one of claims 6 or 7,
**characterized in that**
- the semiconductor laser or an intermediate product which is to be processed to form the semiconductor laser is cleaved from a larger semiconductor crystal (bar) prior to the growth of the first passivation layer (1), so that
- the resonator end faces are formed by the cleaved edges.

9. Method according to claim 8,
**characterized in that**
- the semiconductor laser is cleaved inside the epitaxy reactor which is used for the growth of the first passivation layer (1).

10. Method according to one of the preceding claims,
**characterized in that**
- after the first passivation layer (1) has been applied to its outer surface, a second passivation layer (2) is deposited,
- which consists of a material by which the surface of the first passivation layer (1) can be passivated.

11. Method according to claim 10,
**characterized in that**
- the second passivation layer (2) is selected from the group of materials consisting of Si, Ge, Sb, SiNₓ, GaNₓ, GaO₂, SiOₓ, Al₂O₃, ZnSe, ZnS.

12. Method according to one of the preceding claims,
**characterized in that**
- the first passivation layer (1) is produced by an exchange reaction between As and P, resulting in the formation of a thin film of InₓGa₁₋ₓAs_{y}P_{1-y} (0 < x < 1 and 0 < y < 1).

13. Method according to one of claims 8 to 12,
**characterized in that**
- a semiconductor crystal (14) is clamped into a device (10),
- the crystal (14) is brought to the required substrate temperature by means of heater rods (12) fitted in the device (10) or by means of heating radiation,
- the atmosphere (molecular beam, gas, liquid) required for the epitaxial growth of the first passivation layer (1) is supplied,
- the crystal (14) is cleaved by rotation about the cleaved edge (axis of rotation),
- the first passivation layer (1) is deposited on one cleaved edge or on both cleaved edges simultaneously.

14. Method according to one of the preceding claims,
**characterized in that**
- a number of semiconductor lasers, which are provided with first and if appropriate second passivation layers (1, 2), are fixed in a device with shadow masks (30),
- the contact metal is deposited by two targeted beams (100, 200), which impinge on the laser bar at an angle such that the entire surface of the laser is coated, but the laser mirrors are not contaminated with metal on account of the shadow masks.

## Revendications

1. Laser à semi-conducteurs sur la base de matériau semi-conducteur III-V, dans lequel
- une première couche de passivation (1) en matériau semi-conducteur III-V est apposée sur au moins une surface extérieure du laser à semi-conducteurs, laquelle forme une surface terminale de résonateur,
**caractérisé en ce que**
- le matériau semi-conducteur III-V est le semi-conducteur de liaison InₓGa₁₋ₓAs_{y}P_{1-y} (0 < x < 1 et 0 < y < 1).

2. Laser à semi-conducteurs selon la revendication 1,
**caractérisé en ce que**
- une seconde couche de passivation (2) est apposée sur la surface extérieure de la couche du semi-conducteur de liaison (1).

3. Laser à semi-conducteurs selon la revendication 2,
**caractérisé en ce que**
- la seconde couche de passivation (2) est choisie parmi le groupe des matériaux Si, Ge, Sb, SiNₓ, GaNₓ, GaO₂, SiOₓ, Al₂O₃, ZnSe, ZnS.

4. Laser à semi-conducteurs selon l'une des revendications précédentes,
**caractérisé en ce que**
- il a résulté d'un clivage d'un plus grand cristal semi-conducteur (barreau) avant l'apposition de la première couche de passivation (1), et
- la surface terminale de résonateur est un plan de cassure du laser à semi-conducteurs.

5. Laser à semi-conducteurs selon l'une des revendications précédentes,
**caractérisé en ce que**
- des premières couches de passivation (1) du semi-conducteur de liaison sont apposées sur les deux surfaces extérieures qui forment les surfaces terminales de résonateur.

6. Procédé pour passiver la surface terminale de résonateur d'un laser à semi-conducteurs sur la base de matériau semi-conducteur III-V,
**caractérisé en ce que**
- la sur-croissance d'une première couche de passivation (1) du semi-conducteur de liaison InₓGa₁₋ₓAs_{y}P_{1-y} (0 < x < 1 et 0 < y < 1) sur la surface terminale de résonateur est réalisée au moyen de l'épitaxie.

7. Procédé selon la revendication 6,
**caractérisé en ce que**
- le laser à semi-conducteurs n'est pas encore muni de métal de contact avant la sur-croissance de la première couche de passivation (1),
- la sur-croissance épitaxiale de la première couche de passivation (1) a lieu à une température qui est plus élevée que la température de diffusion du métal de contact à utiliser,
- le métal de contact est appliqué après la sur-croissance de la première couche de passivation (1).

8. Procédé selon l'une ou l'autre des revendications 6 et 7,
**caractérisé en ce que**
- avant la sur-croissance de la première couche de passivation (1), le laser à semi-conducteurs ou un produit intermédiaire devant être usiné pour obtenir le laser à semi-conducteurs est clivé depuis un plus grand cristal semi-conducteur (barreau), de telle sorte que
- les surfaces terminales de résonateur sont formées par les plans de cassure.

9. Procédé selon la revendication 8,
**caractérisé en ce que**
- le laser à semi-conducteurs est clivé à l'intérieur du réacteur d'épitaxie utilisé pour la sur-croissance de la première couche de passivation (1).

10. Procédé selon l'une des revendications précédentes,
**caractérisé en ce que**
- après l'apposition de la première couche de passivation (1), une seconde couche de passivation (2) est appliquée sur la surface extérieure de celle-ci,
- laquelle est constituée d'un matériau au moyen duquel la surface de la première couche de passivation (1) peut être passivée.

11. Procédé selon la revendication 10,
**caractérisé en ce que**
- la seconde couche de passivation (2) est choisie parmi le groupe des matériaux Si, Ge, Sb, SiNₓ, GaNₓ, GaO₂, SiOₓ, Al₂O₃, ZnSe, ZnS.

12. Procédé selon l'une des revendications précédentes,
**caractérisé en ce que**
- la première couche de passivation (1) est générée par une réaction d'échange entre As et P, à la suite de quoi une mince couche (1) de InₓGa₁₋ₓAs_{y}P_{1-y} (0 < x < 1 et 0 < y < 1) est générée.

13. Procédé selon l'une des revendications 8 à 12,
**caractérisé en ce que**
- un cristal semi-conducteur (14) est coincé dans un dispositif (10),
- le cristal (14) est amené à la température de substrat nécessaire au moyen de tiges chauffantes (12) montées dans le dispositif (10) ou par rayonnement chauffant,
- l'atmosphère (jet moléculaire, gaz, liquide) nécessaire à la sur-croissance épitaxiale de la première couche de passivation (1) est fournie,
- le cristal (14) est clivé par la rotation autour du plan de cassure (axe de rotation),
- la première couche de passivation (1) est appliquée simultanément sur un plan de cassure ou sur les deux plans de cassure.

14. Procédé selon l'une des revendications précédentes,
**caractérisé en ce que**
- un certain nombre de lasers à semi-conducteurs munis de premières et le cas échéant de secondes couches de passivation (1, 2) sont fixés dans un dispositif avec des masques d'ombre (30),
- le métal de contact est appliqué par deux jets orientés (100, 200), lesquels viennent toucher les barreaux laser dans un angle de telle sorte que la surface totale du laser est revêtue, mais que le miroir laser n'est pas contaminé par du métal en raison des masques d'ombre.
